# EUROPÄISCHE PATENTANMELDUNG

(11) **EP 3 859 193 A1**
(43) Veröffentlichungstag der Anmeldung: **04.08.2021**
(21) Anmeldenummer: 21000020.4
(22) Anmeldetag: 22.01.2021
(51) Int. Cl.: F16J 15/06, F16J 15/08, F16J 15/12, H05K 9/00

(54) **DICHTUNG**

(30) Priorität: 28.01.2020 DE 102020000632
(71) Anmelder: KACO GmbH + Co. KG, 74912 Kirchardt (DE)
(72) Erfinder: Lenz, Roland, 74257 Untereisesheim (DE); Fehrenbacher, Cornelius, 74226 Nordheim (DE)
(74) Vertreter: Kohl, Karl-Heinz

(57) **Zusammenfassung**

Die Dichtung hat einen Tragkörper (1), an dem ein Dichtkörper (3) vorgesehen ist und der zumindest in einem über den Dichtkörper (3) vorstehenden Bereich elektrisch leitend ausgebildet ist. Der Dichtkörper (3) dichtet gegen eindringendes Medium ab, während der Tragkörper (1) gegen den Austritt elektrischer Störquellen abschirmt.

## Beschreibung

Mit Einführung der Elektrifizierung bei Straßenfahrzeugen treten neue Anforderungen hinsichtlich der Abdichtung und Abschirmung für die Dichtungen auf, insbesondere im Bereich der Batteriegehäuse sowie der Einhausungen für Leistungselektroniken. So muss die Elektronik gegenüber Umwelteinflüssen geschützt und umgekehrt die Umwelt gegenüber elektromagnetischen Störquellen, wie Wechselfelder bzw. Wellen, gesichert werden.

Bekannte Dichtungsausführungen bestehen aus Moosgummi, Zellkautschuk oder Kombinationen von elektrisch leitenden elastomeren Formdichtungen. Auch leitende Klebemittel sind bekannt, die in Schaltschränken, Gehäusen und dgl. eingesetzt werden.

In einem schwingungsbelasteten Schraubverbund sind diese Dichtungen ungeeignet, weil durch die Schwingungen und /oder auch Mikrobewegungen von Gehäuseteilen die Elastizität des Dichtungsmaterials nachlässt oder gar verlorengeht. Zudem besteht das Problem, dass solche elastomeren Dichtungen sich nur schwierig entfernen lassen, wenn beispielsweise ein Gehäuse geöffnet werden muss. Teilweise müssen die Gehäuseteile von noch anhaftenden Dichtungsteilen gereinigt werden. Besonders häufig kommt es sogar vor, dass der Gehäuseteil nach der Entfernung nachbearbeitet werden muss.

Hinzu kommt, dass leitende Klebemittel/Flüssigdichtungen für Druckanwendungen nicht geeignet sind.

Derartige Dichtungen benötigen als kombinierte Lösungen zu viel Bauraum und sind für die Großserie nicht geeignet. Außerdem sind solche Dichtungen auch nicht oder nur wenig reparaturfreundlich.

Der Erfindung liegt die Aufgabe zugrunde, die gattungsgemäße Dichtung so auszubilden, dass sie den Anforderungen, insbesondere in Straßenfahrzeugen der Automobilindustrie, bezüglich Kosten, Großserientauglichkeit, kompakter Ausbildung und Bauraumoptimierung gerecht wird.

Diese Aufgabe wird bei der gattungsgemäßen Dichtung erfindungsgemäß mit den kennzeichnenden Merkmalen des Anspruches 1 gelöst.

Mit der erfindungsgemäßen Dichtung ist es möglich, nicht nur eine Abdichtung gegenüber äußeren Umwelteinflüssen zu gewährleisten, sondern gleichzeitig auch die Umgebung von elektrischen Störquellen nach EMV abzuschirmen. Die erfindungsgemäße Dichtung vereint somit zwei Funktionen, nämlich die Abdichtung und die Abschirmung. Darum sind zur Erfüllung dieser beiden Funktionen getrennte Bauteile nicht erforderlich. Der Tragkörper der Dichtung dient zum einen als Befestigungsmittel des Dichtkörpers und zum anderen infolge seiner elektrisch leitenden Ausbildung in dem über den Dichtkörper überstehenden Bereich als Abschirmelement gegenüber elektromagnetischen Störquellen.

Der Dichtkörper, der aus elastomerem Material, bevorzugt aus Silikon, besteht, kann gegenüber eindringendem Medium bis IP-Klasse 9K eingesetzt werden. Die IP-Schutzklasse 9K bietet einen Schutz gegen sehr intensiven Wasserstrahl, z. B. Hochdruck-Dampfstrahlreiniger bei Fahrzeugen. Insbesondere wird mit der Dichtung das entsprechend abgedichtete Gehäuse in einem Fahrzeug bei Wasserdurchfahrten einwandfrei abgedichtet. Dies ist insbesondere dann wichtig, wenn mit der Dichtung ein Batteriegehäuse abgedichtet wird, in dem sich Lithiumbatterien befinden. Darüberhinaus zeichnet sich der Dichtkörper der erfindungsgemäßen Dichtung durch eine hohe Klimawechsel-Festigkeit und Salzsprühnebel-Festigkeit aus. Mit der Dichtung kann auch eine schädliche Kontaktkorrosion vermieden werden.

Der über den Dichtkörper vorstehende Bereich des Tragkörpers kommt in elektrisch leitenden Kontakt mit denjenigen Bauteilen, zwischen denen die Dichtung eingebaut wird. Die Dichtung schirmt somit das Gehäuse gegen Austritt elektrischer Störquellen zuverlässig ab.

Um eine gute elektrisch leitende Verbindung zwischen den Bauteilen zu erreichen, ist der über den Dichtkörper vorstehende Bereich des Tragkörpers verformbar, vorteilhaft elastisch verformbar. In der Einbaulage liegt der vorstehende Tragkörperbereich, wenn er elastisch verformt ist, unter Vorspannung an den beiden Bauteilen an, zwischen denen die Dichtung eingespannt ist.

Grundsätzlich kann es auch ausreichen, wenn der vorstehende Bereich des Tragkörpers plastisch verformt ist.

Vorteilhaft besteht der gesamte Tragkörper aus elektrisch leitendem Material. Dies ermöglicht eine einfache und kostengünstige Fertigung des Tragkörpers.

Hierfür ist es besonders vorteilhaft, wenn der Tragkörper aus einem Metallblech gebildet wird. Es ermöglicht eine einfache und kostengünstige Herstellung des Tragkörpers. So kann der Tragkörper in einfacher Weise aus dem Metallblech in einem Stanzverfahren, einem Strahlschneideverfahren und dgl. herausgetrennt werden, wobei der Tragkörper je nach Einsatzort der Dichtung unterschiedlichste Umrissformen haben kann.

Um eine gute elektrisch leitende Verbindung zwischen den abzudichtenden Bauteilen zu erreichen, ist zumindest der über den Dichtkörper vorstehende Bereich des Tragkörpers als Formteil ausgebildet. Er kann so gestaltet sein, dass er zwischen den gegeneinander abzudichtenden Bauteilen so elastisch verformt wird, dass er unter einer ausreichend hohen Vorspannkraft an den einander zugewandten Seiten der Bauteile anliegt.

Der vorstehende Bereich des Tragkörpers kann bei einer bevorzugten Ausbildung als Formteil eine rippenförmige Struktur aufweisen. Eine solche Struktur bietet sich dann an, wenn sich an den einander zugewandten Seiten der Bauteile Sperrschichten, wie Oxidschichten, befinden oder auch bilden können, die eine elektrisch leitende Verbindung zwischen den Bauteilen und dem Tragkörper erschweren oder gar verhindern. In diesem Falle wird eine solche Sperrschicht durch die Rippen durchbrochen, so dass ein einwandfreier Kontakt zwischen dem Tragkörper und den Bauteilen gewährleistet ist.

Die Rippen können hierbei in vorteilhafter Weise spitz auslaufen, wodurch das Durchdringen einer Sperrschicht erheblich vereinfacht wird.

Es besteht weiter die Möglichkeit, den über den Dichtkörper vorstehenden Bereich des Tragkörpers gegenüber demjenigen Bereich, an dem der Dichtkörper vorgesehen ist, quer zur Ebene des Tragkörpers versetzt anzuordnen. Der den Dichtkörper aufweisende Tragkörperbereich liegt somit in einer anderen Ebene als der vorstehende Tragkörperbereich. Werden die Bauteile unter Zwischenlage der Dichtung miteinander fest verbunden, wird auf Grund dieser Gestaltung des Tragkörpers der versetzt angeordnete Tragkörperbereich zuverlässig elastisch verformt, wodurch die elektrisch leitende Verbindung zwischen den Bauteilen über den Tragkörper gewährleistet ist.

Die elektrisch leitende Verbindung zwischen den Bauteilen kann bei einer vorteilhaften Ausbildung dadurch verbessert werden, dass der über den Dichtkörper vorstehende Tragkörperbereich quer zur Längsrichtung des Tragkörpers profiliert ausgebildet ist.

Eine solche Profilierung kann durch in Umfangsrichtung hintereinander liegende Profilteile gebildet sein. Sie können unmittelbar aneinander anschließen, aber auch jeweils Abstand voneinander haben. Diese Profilteile werden beim Zusammenfügen der Bauteile zuverlässig elastisch verformt, wodurch sich eine gute elektrische Kontaktierung zwischen den Bauteilen und dem Tragkörper ergibt.

Bei einer einfachen und kostengünstigen Ausführungsform sind die Profilteile des Tragkörpers wellenförmig ausgebildet.

Bei einer anderen vorteilhaften Ausbildung verläuft die am vorstehenden Tragkörperbereich vorgesehene Profilierung in Längsrichtung des Tragkörpers. Sie ist im Querschnitt vorteilhaft wellenförmig ausgebildet, wobei die Wellen quer zur Längsrichtung des Tragkörpers hintereinander liegen. Auch diese Profilierung wird beim Zusammenfügen der Bauteile elastisch verformt und sorgt für eine gute Kontaktierung.

Es ist weiter möglich, den Tragkörper mit wenigstens einem Formschlussmittel zu versehen. Mit ihm kann die Positionierung der Dichtung relativ zu den Bauteilen einfach erreicht werden. Außerdem können diese Formschlussmittel auch zur zusätzlichen Kontaktierung mit den Bauteilen herangezogen werden.

Die Formschlussmittel können beispielhaft quer zum Tragkörper sich erstreckende Elemente sein, vorzugsweise quer abstehende Laschen.

Eine weitere Möglichkeit, die Kontaktierung zwischen dem Tragkörper und den Bauteilen zu verbessern, besteht in vorteilhafter Weise darin, den vorstehenden Teil des Tragkörpers mit mindestens einem vorstehenden Zapfen zu versehen. Er wird beim Zusammenfügen der Bauteile mit hoher Kraft verpresst, was zur guten Kontaktierung beiträgt.

Eine weitere Verbesserung der elektrisch leitenden Verbindung zwischen den Bauteilen und dem Tragkörper kann dadurch erreicht werden, dass zumindest der vorstehende Bereich des Tragkörpers mit einer elektrisch leitenden Beschichtung versehen ist. Dann muss der Tragkörper selbst nicht aus elektrisch leitendem Material bestehen, was sich in geringeren Herstellkosten niederschlagen kann.

Damit die Abdichtung gegen äußere Einflüsse optimiert wird, ist es vorteilhaft den Dichtkörper an zumindest einer Seite des Tragkörpers mit einer Profilierung zu versehen. Sie wird beim Zusammenfügen der gegeneinander abzudichtenden Bauteile elastisch verformt, wodurch sich eine einwandfreie Abdichtung ergibt.

Damit der über den Dichtkörper vorstehende Bereich des Tragkörpers die Funktion des Dichtkörpers nicht beeinträchtigt, ist es vorteilhaft, wenn die Dicke des Tragkörpers kleiner ist als die Höhe des abzudichtenden Dichtspaltes zwischen den Bauteilen. Durch eine solche Gestaltung ist auf jeden Fall sichergestellt, dass der Dichtkörper durch die Bauteile elastisch verformt wird.

Der Anmeldungsgegenstand ergibt sich nicht nur aus dem Gegenstand der einzelnen Patentansprüche, sondern auch durch alle in den Zeichnungen und der Beschreibung offenbarten Angaben und Merkmale. Sie werden, auch wenn sie nicht Gegenstand der Ansprüche sind, als erfindungswesentlich beansprucht, soweit sie einzeln oder in Kombination gegenüber dem Stand der Technik neu sind.

Weitere Merkmale der Erfindung ergeben sich aus den weiteren Ansprüchen, der Beschreibung und den Zeichnungen.

Die Erfindung wird anhand einiger in den Zeichnungen dargestellter Ausführungsformen näher erläutert. Es zeigen
- Fig. 1: in perspektivischer Darstellung eine erfindungsgemäße Dichtung,
- Fig. 2: in perspektivischer Darstellung einen Teil einer zweiten Ausführungsform einer erfindungsgemäßen Dichtung,
- Fig. 2a: in einem Schnitt eine weitere Ausführungsform eines Tragkörpers der erfindungsgemäßen Dichtung,
- Fig. 3 bis Fig. 5: jeweils im Schnitt und in vergrößerter Darstellung unterschiedliche Ausbildungen eines Tragkörpers der erfindungsgemäßen Dichtung,
- Fig. 6: in perspektivischer Darstellung einen Teil eines Tragkörpers der erfindungsgemäßen Dichtung,
- Fig. 7: in vergrößerter Darstellung einen Schnitt durch den Tragkörper gemäß Fig. 6,
- Fig. 8: in perspektivischer Darstellung einen Teil einer weiteren Ausführungsform eines Tragkörpers der erfindungsgemäßen Dichtung,
- Fig. 9: in vergrößerter Darstellung einen Schnitt durch den Tragkörper gemäß Fig. 8,
- Fig. 10: in einem Schnitt eine weitere Ausführungsform eines Tragkörpers einer erfindungsgemäßen Dichtung,
- Fig. 11: in schematischer Darstellung einen Teil einer erfindungsgemäßen Dichtung, die zwischen zwei Bauteilen angeordnet ist,
- Fig. 12 und 13: zusätzliche Kontaktstellen im Tragkörper der erfindungsgemäßen Dichtung, jeweils im Schnitt und in vergrößerter Darstellung,
- Fig. 14 und 15: jeweils in perspektivischer Darstellung Ausführungsformen von Kontaktstellen im Tragkörper der erfindungsgemäßen Dichtung,
- Fig. 16 bis 21: jeweils im Schnitt und in vergrößerter Darstellung unterschiedliche Ausführungsformen von Dichtkörpern der erfindungsgemäßen Dichtung,
- Fig. 22: in schematischer Darstellung und im Schnitt einen Tragkörper der erfindungsgemäßen Dichtung mit einer weiteren Ausführungsform des Dichtkörpers,
- Fig. 22a: einen Schnitt längs der Line A -A in Fig. 22 in vergrößerter Darstellung,
- Fig. 22b: einen Schnitt längs der Linie B - B in Fig. 22 in vergrößerter Darstellung,
- Fig. 23: im Schnitt einen zwischen zwei Bauteilen eingespannten Tragkörper der erfindungsgemäßen Dichtung in einer weiteren Ausführungsform,
- Fig. 24: in schematischer Darstellung und im Schnitt einen zwischen zwei Bauteilen eingespannten Tragkörper der erfindungsgemäßen Dichtung,
- Fig. 25: in perspektivischer Darstellung eine weitere Ausführungsform einer erfindungsgemäßen Dichtung.

Die im Folgenden beschriebene Dichtung ist als Kombidichtung ausgebildet, die als Dicht- und als Abschirmelement zwischen Bauteilen, vorzugsweise im Automobilbereich, eingesetzt werden kann. Die Dichtung ist so ausgebildet, dass sie eine Abschirmung von elektrischen Störquellen nach EMV (elektromagnetische Verträglichkeit) und zur Abdichtung gegenüber eindringenden Medien eingesetzt werden kann. Hierbei ist die Dichtwirkung so gestaltet, dass sie den IP-Forderungen der Klasse 9K genügt. Die IP-Klasse 9K stellt sicher, dass ein Schutz gegen Wasser bei einer Hochdruck/Dampfstrahlreinigung, insbesondere für Straßenfahrzeuge, gewährleistet ist.

Die Dichtung hat einen Tragkörper, der als Träger eines elastomeren Dichtkörpers dient und außerdem als elektrisch leitendes Abschirmelement dient. Der Tragkörper kombiniert auf diese Weise vorteilhaft beide Funktionen in einem einzigen Bauteil.

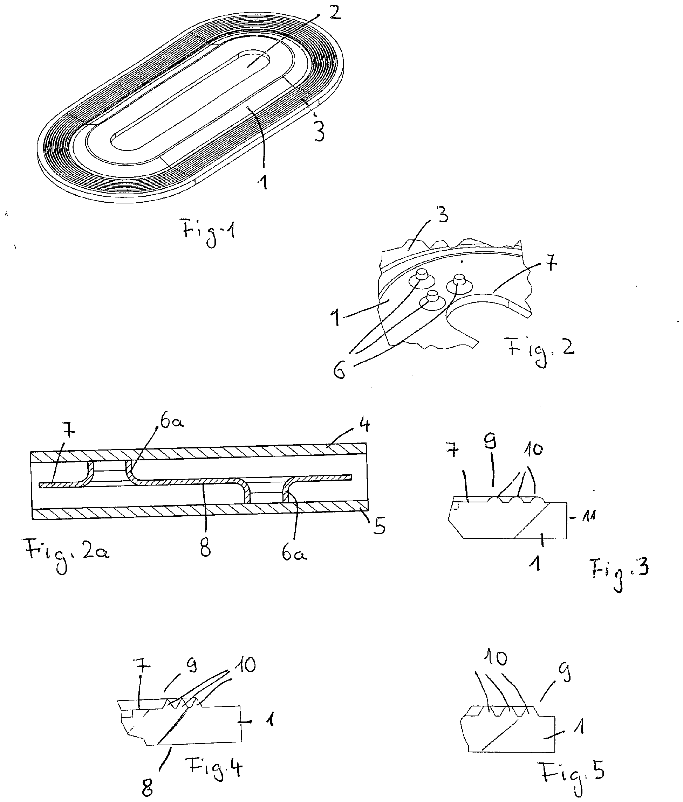

Fig. 1 zeigt beispielhaft eine solche Dichtung, die als länglich ovaler Dichtring ausgebildet ist. Die dargestellte Gestaltung der Dichtung ist nur beispielhaft zu verstehen. Je nach Einsatzgebiet kann die Dichtung unterschiedlichste Umrissformen haben.

Die Dichtung hat einen Tragkörper 1, der gleiche Umrissform wie die gesamte Dichtung hat. Der Tragkörper 1 ist als Ring ausgebildet und weist mittig eine Öffnung 2 auf.

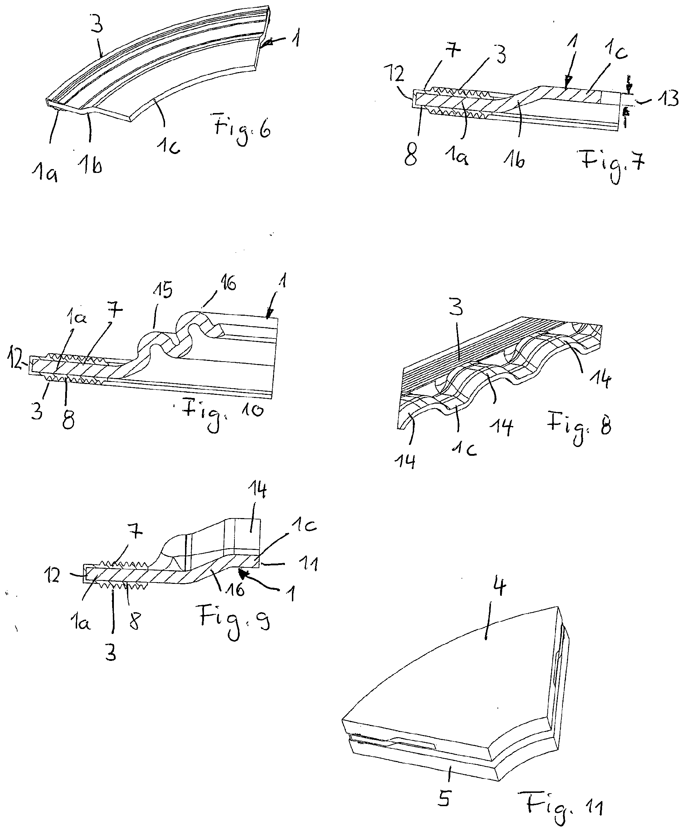

Der Tragkörper 1 ist an zumindest einer Seite mit einem Dichtkörper 3 versehen, der gegen den Zutritt von Schmutz, Feuchtigkeit und dgl. abdichtet. Der Dichtkörper ist nicht über die gesamte Breite des Tragkörpers 1 vorgesehen, der zumindest nach innen über den Dichtkörper 3 übersteht. Der Tragkörper 1 dient als elektrisch leitendes Abschirmelement und wird in der Einbaulage der Dichtung zwischen gegeneinander abzudichtenden Bauteilen 4, 5 (Fig. 11) elastisch verformt, die beispielhaft Gehäuseteile sind und nachfolgend auch als Gehäuseteile bezeichnet werden.

Der Tragkörper 1 besteht aus elektrisch leitendem Material. Vorteilhaft wird der Tragkörper 1 aus einem metallischen Werkstoff hergestellt, der eine kostengünstige Fertigung ermöglicht. Als metallischer Werkstoff kann vorteilhaft Stahl oder Aluminium verwendet werden.

Es besteht weiter die Möglichkeit, den Tragkörper 1 aus einem elektrisch leitenden Kunststoff zu fertigen. Er ist vorteilhaft ein Duroplast, der eine ausreichende Festigkeit aufweist und zwischen den beiden gegeneinander abzudichtenden Gehäuseteilen 4, 5 verformt werden kann.

Es ist möglich, zumindest den über den Dichtkörper 3 vorstehenden Bereich des Tragkörpers 1 mit einer elektrisch leitenden Beschichtung zu versehen. Dann muss der Tragkörper 1 selbst nicht aus einem elektrisch leitenden Material bestehen. Dies kann zu geringeren Herstellungskosten der Dichtung führen.

Der Dichtkörper 3 besteht vorteilhaft aus elastomerem Material, bevorzugt aus Silikon. Der Dichtkörper 3 ist in geeigneter Weise auf dem Tragkörper 1 befestigt, beispielsweise aufgeklebt, bei entsprechendem Material aufvulkanisiert und dgl.

Der Tragkörper 1 ist über seine Breite und/oder Länge derart geformt, dass er beim Einpressen zwischen den beiden Gehäuseteilen 4, 5 (Fig. 11) elastisch verformt wird. Dann verbindet der elektrisch leitende Tragkörper 1 beide Gehäuseteile 4, 5 elektrisch leitend miteinander. Der Tragkörper 1 ist so ausgebildet, dass er die beiden Gehäuseteile 4, 5 über seinen Umfang elektrisch leitend miteinander verbindet.

Um die elektrisch leitende Verbindung zwischen den Gehäuseteilen 4, 5 zu verbessern, kann der Tragkörper 1, wie Fig. 2 beispielhaft zeigt, mit vorstehenden Zapfen 6 versehen sein, die aus elektrisch leitendem Material bestehen und über den Umfang des Tragkörpers 1 verteilt angeordnet sind. Die Zapfen 6 können über die eine Seite 7, aber auch über die gegenüberliegende Seite 8 des Tragkörpers 1 vorstehen. Auch kann der Tragkörper 1 so gestaltet werden, dass er auf beiden Außenseiten 7, 8 die vorstehenden Zapfen 6 aufweist. Sie sind elektrisch leitend mit dem Tragkörper 1 verbunden und so lang, dass sie in der Einbaulage der Dichtung zwischen den beiden Gehäuseteilen 4, 5 elektrisch leitenden Kontakt mit ihnen haben. Die Zapfen 6 werden beim Verpressen der Dichtung zwischen den beiden Gehäuseteilen 4, 5 verpresst, wodurch ein guter Kontakt zwischen den Zapfen 6 und den Gehäuseteilen 4, 5 gewährleistet ist.

Der Tragköper 1 kann in seinem über den Dichtkörper 3 vorstehenden Bereich anstelle der Zapfen 6, gegebenenfalls auch zusätzlich zu ihnen, mit Aushalsungen 6a versehen sein (Fig. 2a). Sie stehen über die eine und/oder die andere Außenseite 7, 8 des Tragkörpers 1 vor. Die Aushalsungen 6a sind hülsenförmig ausgebildet und können in bekannter Weise mit einem Aushalswerkzeug hergestellt werden.

In gleicher Weise wie die Zapfen 6 werden auch die Aushalsungen 6a beim Zusammenfügen der Gehäuseteile 4, 5 verpresst und somit eine sichere Kontaktierung erreicht.

Fig. 3 zeigt die Möglichkeit, den Tragkörper 1 an zumindest einer Außenseite 7 mit einer Profilierung 9 zu versehen. Sie wird durch über den Umfang des Tragkörpers verlaufende Erhöhungen 10 gebildet, die geringen Abstand voneinander haben und im Schnitt etwa halbkreisförmig ausgebildet sind.

Wird die Dichtung zwischen den Gehäuseteilen 4, 5 eingespannt, sorgen die ringförmig umlaufenden Erhöhungen 10 dafür, dass auf der Kontaktseite der Gehäuseteile befindliche Oxidschichten durchbrochen werden, so dass die leitende Verbindung zwischen den Gehäuseteilen 4, 5 über den Tragkörper 1 der Dichtung sichergestellt ist. Solche Oxidschichten bilden sich insbesondere dann, wenn die Gehäuseteile 4, 5 aus Aluminium bestehen.

Im Vergleich zur Dicke des Tragkörper 1 haben die Erhöhungen 10 nur eine geringe Höhe. Die Erhöhungen 10 sind nur so hoch, dass sie eventuelle

Oxidschichten an den Kontaktbereichen zu den Gehäuseteilen 4, 5 durchbrechen können.

Der Tragkörper 1 besteht - dies gilt auch für die weiteren Ausführungsbeispiele - vorteilhaft aus einem Metallblech, das eine einfache und kostengünstige Herstellung des Tragkörper 1 ermöglicht. Die Erhöhungen 10 können hierbei durch einen einfachen Prägevorgang erzeugt werden.

Die Erhöhungen 10 haben jeweils gleiche Höhe und jeweils gleichen Abstand voneinander. Je nach Anwendungsfall ist es möglich, dass die Erhöhungen 10 unterschiedliche Höhe und/oder unterschiedlichen Abstand voneinander haben.

Die Profilierung 9 hat Abstand vom Rand 11 der Öffnung 2.

Beim Ausführungsbeispiel nach Fig. 4 ist die Profilierung 9 sägezahnartig ausgebildet. Die Erhöhungen 10 schließen hierbei jeweils aneinander an und sind spitz auslaufend ausgebildet. Mit ihrer spitzen Stirnseite können eventuell vorhandene Oxidschichten in den Kontaktbereichen zu den Gehäuseteilen 4, 5 zuverlässig durchbrochen werden, so dass eine einwandfreie elektrisch leitende Verbindung zwischen den Gehäuseteilen 4, 5 über den Tragkörper 1 gewährleistet ist.

Die Profilierung 9 ist im Übrigen gleich ausgebildet wie bei der vorigen Ausführungsform. Der Tragkörper 1 kann die Profilierung nicht nur an der einen Außenseite 7, sondern auch an der gegenüberliegenden Außenseite 8 des Tragkörpers 1 aufweisen. Dies ist auch bei der Ausführungsform gemäß Fig. 3 sowie bei den nachfolgend noch beschriebenen Ausführungsformen möglich.

Sind die Profilierungen 9 an beiden Außenseiten 7, 8 des Tragkörpers 1 vorgesehen, können sie auf beiden Seiten gleich, aber auch unterschiedlich ausgebildet sein. Dies ist problemlos möglich, weil die Profilierungen 9, wenn der Tragkörper 1 aus einem Blech besteht, durch einen einfachen Prägevorgang hergestellt werden können.

Auch wenn der Tragkörper 1 aus einem elektrisch leitenden Kunststoff besteht oder mit einer elektrisch leitenden Beschichtung versehen ist, können die Profilierungen 9 an zumindest einer der beiden Außenseiten 7, 8 des Tragkörpers 1 einfach vorgesehen werden.

Die Kontaktteile 6, 9 der Ausführungsformen gemäß den Fig. 2 bis 5 sind im Bereich neben dem Dichtkörper 3 vorgesehen. Die Zapfen 6 bzw. die Profilierungen 9 sind so ausgebildet, dass mit dem Dichtkörper 3 eine Abdichtung zwischen den beiden Gehäuseteilen 4, 5 erreicht wird, und dass mit den Zapfen 6 bzw. den Aushalsungen 6a bzw. den Profilierungen 9 zusätzlich auch der elektrisch leitende Kontakt zwischen den beiden Gehäuseteilen 4, 5 hergestellt werden kann.

Bei der Ausführungsform gemäß den Fig. 6 und 7 ist der Tragkörper 1 nicht mit Zapfen oder Profilierungen ausgebildet. Der nach innen über den Dichtkörper 3 vorstehende Teil des Tragkörpers 1 ist im Querschnitt abgewinkelt verlaufend ausgebildet. Im äußeren Bereich 1a ist der Tragkörper 1 auf beiden Außenseiten 7, 8 vom Dichtkörper 3 ummantelt. Der Dichtkörper 3 erstreckt sich auch über den äußeren Rand 12 des Tragkörpers 1. Der vom Dichtkörper 3 umgebene äußere Tragkörperteil 1a ist eben und wird über einen kegelförmigen Mittelteil 1b mit einem inneren ebenen Tragkörperteil 1c verbunden. Er liegt in der Darstellung gemäß den Fig. 6 und 7 im Bereich oberhalb des äußeren Tragkörperteils 1a und des auf der Außenseite 7 vorhandenen Teils des Dichtkörpers 3.

Der Dichtkörper 3 kann sich bis zum kegelförmigen Mittelteil 1b erstrecken aber auch Abstand von ihm haben.

Wird eine solche Dichtung zwischen den beiden Gehäuseteilen 4, 5 verspannt (Fig. 11), wird der innere Tragkörperteil 1c zwischen den beiden

Gehäuseteilen 4, 5 elastisch verformt. Der Tragkörperteil 1c wird hierbei bis auf Dichthöhe so weit zusammengedrückt, bis die Dichtspalthöhe zwischen den Gehäuseteilen 4, 5 erreicht ist. Dann liegt der Tragkörperteil 1c elektrisch leitend an den einander zugewandten Innenseiten der beiden Gehäuseteile 4, 5 an. Gleichzeitig wird der Dichtkörper 3 zwischen beiden Gehäuseteilen 4, 5 elastisch so weit verformt, dass eine einwandfreie Abdichtung sichergestellt ist. Auf diese Weise wird über den Umfang der Dichtung die Abdichtung zwischen den Gehäuseteilen 4, 5 mittels des Dichtkörpers 3 und die elektrisch leitende Verbindung der Gehäuseteile 4, 5 mittels des Tragkörpers 1 erreicht.

Der innere Tragkörperteil 1c kann die Zapfen 6 bzw. Profilierungen 9 aufweisen, wie sie beispielhaft in den Fig. 2 bis 5 dargestellt sind. Sie gewährleisten in der beschriebenen Weise eine zuverlässige elektrisch leitende Verbindung zwischen den Gehäuseteilen 4, 5.

Bei der elastischen Verformung des einstückigen Tragkörpers 1 wird auch der kegelförmige Mittelteil 1b elastisch verformt, der in Verbindung mit dem inneren Tragkörperteil 1c die Kontaktierung der beiden Gehäuseteile 4, 5 gewährleistet.

Wie Fig. 7 zeigt, ist der Übergang vom Mittelteil 1b zum Außenteil 1a so gestaltet, dass an dieser Übergangsstelle der Tragkörper 1 mit einem der beiden Gehäuseteile 4, 5 in Kontakt kommen kann. Der die Außenseite 8 bedeckende Teil des Dichtkörpers 3 hat Abstand vom Übergangsbereich zwischen dem Außenteil 1a und dem Mittelteil 1b.

Wie aus Fig. 6 hervorgeht, kann dieser Übergangsbereich, der nicht vom Dichtkörper 3 bedeckt ist, eine ausreichend große Breite haben, so dass der Tragkörper 1 in der Einbaulage die beiden Gehäuseteile 4, 5 zuverlässig elektrisch leitend miteinander verbinden kann.

Die Dicke 13 des Tragkörpers 1 (Fig. 7) ist kleiner als die Dichtspalthöhe zwischen den beiden Gehäuseteilen 4, 5. Durch dieses Wirkprinzip kann die Vorspannkraft bzw. die Verspannung unabhängig von den beiden Funktionen der Dichtung jeweils vorteilhaft entweder für die Dichtwirkung des Dichtkörpers 3 oder der elektrisch leitenden Verbindung mittels des Tragkörpers 1 ausgelegt werden.

Bei der Ausführungsform gemäß den Fig. 8 und 9 ist der äußere Tragkörperteil 1a des Tragkörpers 1 in der beschriebenen Weise durch den Dichtkörper 3 an den beiden Außenseiten 7, 8 und am Außenrand 12 bedeckt, wie anhand der Fig. 6 und 7 erläutert worden ist.

Während bei der vorigen Ausführungsform der kegelförmige Mittelteil 1b und der Innenteil 1c im Schnitt gerade ausgebildet sind, sind bei der Ausführungsform nach den Fig. 8 und 9 beide Teile in Umfangsrichtung wellenförmig profiliert ausgebildet. Der Tragkörper 1 hat dementsprechend in Umfangsrichtung verlaufende Wellen 14, die sich vom Umfangsrand 11 der Öffnung 2 der Dichtung aus bis zum äußeren Tragkörperteil 1a erstrecken. Die Wellen 14 liegen in Umfangsrichtung des Tragkörpers 1 mit Abstand hintereinander.

Die Wellen 14 sind so gestaltet, dass sie sich bis in den Tragkörperteil 1a erstrecken können.

Die Wellen 14 können, in einem in Umfangsrichtung geführten Schnitt gesehen, wellenförmig ausgebildet sein.

Da die Wellen 14 über die Außenseite 7 im Bereich des Tragkörperteils 1a vorstehen, werden sie beim Verspannen zwischen den Gehäuseteilen 4,5 elastisch verformt, wodurch eine einwandfreie elektrisch leitende Verbindung zwischen den Gehäuseteilen 4, 5 erreicht wird.

Der Dichtkörper 3 erstreckt sich an der Außenseite 8 des Tragkörpers 1 bzw. seines äußeren Tragkörperteiles 1a nur über einen Teil seiner Breite, beispielsweise nur über die halbe Breite des Tragkörperteiles 1a. Dies trägt zur guten elektrisch leitenden Verbindung zwischen den Gehäuseteilen 4, 5 über den Tragkörper 1 bei.

Die Wellen 14, die über den Umfang der Tragkörperteile 1b, 1c vorgesehen sind, können durch einen einfachen Verformungsvorgang hergestellt werden.

Während beim zuvor beschriebenen Ausführungsbeispiel die Verformung in Umfangsrichtung des Tragkörper 1 vorgesehen ist, zeigt Fig. 10 ein Beispiel dafür, dass die Profilierung der Tragkörperteile 1b, 1c auch über die Breite des Tragkörper 1 vorgesehen sein kann. Beide Teile können im Schnitt jeweils bogenförmig gekrümmt ausgebildet sein. Dadurch ergibt sich, über die Breite des Tragkörper 1 gesehen, ein etwa mäanderförmiger Querschnittsverlauf der Profilierungen 15, 16 der beiden Tragkörperteile 1b und 1c. Die beiden Profilierungen 15, 16 ragen über die Außenseite 7 des Tragkörperteiles 1a vor, der entsprechend der vorherigen Ausführungsform durch den Dichtkörper 3 bedeckt ist, der sich über den Außenrand 12 bis zur Außenseite 8 des Tragkörperteiles 1a erstreckt. Wird eine solche Dichtung zwischen den beiden Gehäuseteilen 4, 5 verspannt, werden diese elastisch so weit verformt, bis der Dichtkörper 3 entsprechend den vorherigen Ausführungsformen dichtend an den einander zugewandten Innenseiten der Gehäuseteile 4, 5 anliegt. Da die in der Einbaulage elastisch verformten Profilierungen 15, 16 unter Vorspannung an den Gebäudeteilen 4, 5 anliegen, ergibt sich eine sichere elektrisch leitende Verbindung zwischen den Gehäuseteilen 4, 5 über den Tragkörper 1 der Dichtung.

Die wellenförmigen Profilierungen 15, 16 verlaufen in Umfangsrichtung des Tragkörpers 1. Dadurch ergibt sich über den Umfang der Dichtung eine gute Kontaktierung des Tragkörpers 1 zu den Gehäuseteilen 4, 5.

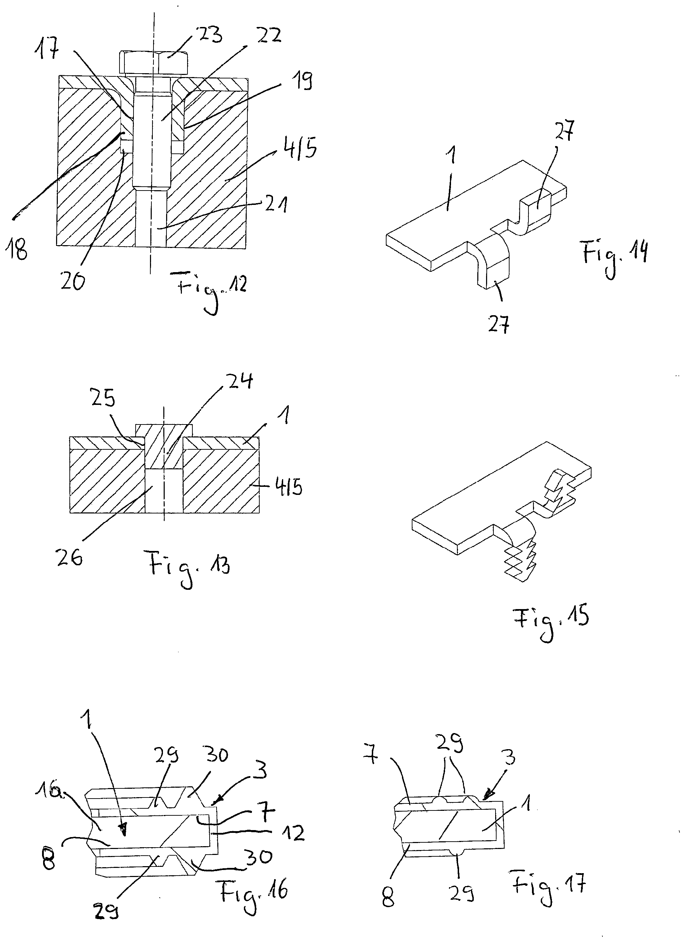

Die Fig. 12 und 13 zeigen die Möglichkeit, den Tragkörper 1 formschlüssig mit einem oder mit beiden der gegeneinander abzudichtenden Gehäuseteile 4, 5 zu verbinden. Der Tragkörper 1 ist mit wenigstens einer Befestigungsöffnung 17 versehen, deren Rand 18 zur Bildung einer Hülse verformt ist. Sie wird in eine entsprechende Stecköffnung 19 im Gehäuseteil 4, 5 gesteckt, in deren Boden 20 eine Gewindebohrung 21 mündet. Die Hülse 18 dient als Zentrierung des Tragkörpers 1 und damit der Dichtung relativ zum Gehäuseteil 4, 5 und liegt an der Seitenwand der Stecköffnung 19 an. Durch die Hülse 18 wird eine Schraube 22 gesteckt, die in die Gewindebohrung 21 des Gehäuseteiles 4, 5 geschraubt wird. Die Schraube 22 liegt mit ihrem Kopf 23 auf dem Tragkörper 1 auf und drückt ihn gegen die entsprechende Außenseite des Gehäuseteiles 4, 5.

Um eine sichere Befestigung des Tragkörpers 1 am Gehäuseteil 4, 5 zu erreichen, hat die Hülse 19 Abstand vom Boden 20 der Stecköffnung 19, so dass der Tragkörper 1 mit der Schraube 22 fest gegen das Gehäuseteil 4, 5 gedrückt werden kann.

Je nach Größe der Dichtung und damit des Tragkörpers 1 können über den Umfang verteilt mehrere solcher Befestigungseinrichtungen vorgesehen sein.

Die Befestigungsöffnung 17 befindet sich im inneren Tragkörperteil 1c. Anstelle der Schraube 22 kann auch ein Passstift verwendet werden.

Fig. 13 zeigt die Möglichkeit, den Tragkörper 1 mittels Clinchen (Durchsetzfügen) an wenigstens einem Gehäuseteil 4, 5 zu befestigen. Der Tragkörper 1 hat eine Öffnung 25, die einen Befestigungskörper 24 aufnimmt. Das Gehäuseteil 4, 5 ist mit einer Öffnung 26 versehen, in welche der Befestigungskörper 24 eingepresst wird.

Wie bei der Ausführungsform gemäß Fig. 12 kann der Tragkörper 1 mittels mehrerer Befestigungskörper 24 mit dem Gehäuseteil 4, 5 verbunden werden. Die Öffnungen 25 sind im inneren Tragkörperteil 1c vorgesehen und über den Umfang verteilt angeordnet, sofern mehrere Befestigungskörper 24 eingesetzt werden.

Mittels der Befestigungskörper 24 wird die Dichtung am jeweiligen Gehäuseteil 4, 5 fixiert und gleichzeitig auch in der Einbaulage relativ zu den Gehäuseteilen 4, 5 positioniert.

Beim Ausführungsbeispiel gemäß Fig. 14 ist der Tragkörper 1 am inneren/ äußeren Rand mit nach oben und unten abgebogenen Laschen 27 versehen, denen entsprechende Aufnahmen im Gehäuseteil 4, 5 zugeordnet sind. Die Laschen 27 sind gegenüber dem Tragkörper 1 jeweils um 90° nach oben und unten abgebogen.

Beim Ausführungsbeispiel nach Fig. 15 sind die Laschen 27 an ihren Längsrändern mit einem Sägezahnprofil 28 versehen, mit dem eine zuverlässige Verbindung mit den Gehäuseteilen 4, 5 möglich ist.

Mit der Ausbildung des Tragkörpers 1 entsprechend den Fig. 12 bis 15 wird die Dichtung relativ zu den Gehäuseteilen 4, 5 in einfacher Weise in ihrer Lage positioniert. Gleichzeitig stellen die Formschlussteile des Tragkörpers 1 zusätzliche Kontaktstellen dar, die die elektrisch leitende Verbindung zwischen dem Tragkörper 1 und den Gehäuseteilen 4, 5 verbessern.

Die Laschen 27 gemäß den Fig. 14 und 15 können abweichend von der dargestellten Ausführungsbildung auch jede andere geeignete Gestalt haben, um eine formschlüssige Verbindung zwischen dem Tragkörper 1 und den Gehäuseteilen 4, 5 zu erreichen. Die Laschen 27 können hierbei so ausgebildet sein, dass sie in die Gehäuseteile 4, 5 beim Zusammenschrauben der Gehäuseteile unter Zwischenlage der Dichtung eingepresst werden.

Der Dichtkörper 3 der Dichtung kann unterschiedlichste Gestalt haben, was beispielhaft anhand der Fig. 16 bis 21 erläutert wird.

Bei der Ausführungsform gemäß Fig. 16 ist der Dichtkörper 3 so ausgebildet, dass er den Tragkörper bzw. seinen Tragkörperteil 1a auf seinen beiden Außenseiten 7, 8 sowie am Außenrand 12 bedeckt. Der Dichtkörper 3 erstreckt sich in vorteilhafter Weise nur über einen Teil der Breite des Tragkörperteiles 1a sowie über dessen gesamten Umfang. Dadurch ist gewährleistet, dass über den Umfang der Dichtung die beiden Gehäuseteile 4, 5 einwandfrei gegeneinander abgedichtet sind.

Je nach Anwendungsfall kann der Außenrand 12 des Tragkörpers 1 auch frei liegen, das heißt nicht vom Dichtkörper 3 bedeckt sein.

Der Dichtkörper 3 ist an beiden Außenseiten mit ringförmigen Vorsprüngen 29, 30 versehen, die unterschiedliche Höhe haben und sich über den Umfang der Dichtung erstrecken. Der benachbart zum Außenrand 12 liegende Vorsprung 30 hat eine größere Höhe als der zu ihm benachbarte Vorsprung 29.

Die beidseitig des Tragkörpers 1 befindlichen ringförmigen Vorsprünge 29, 30 sind jeweils gleich ausgebildet.

Da die beiden ringförmigen Vorsprünge 29, 30 unterschiedlich hoch sind, wird beim Zusammenschrauben der Gehäuseteile 4, 5 auf jeden Fall sichergestellt, dass zumindest der höhere Ringvorsprung 30 beim Zusammenschrauben der Gehäuseteile 4, 5 elastisch verformt wird. Vorteilhaft wird aber auch der andere Vorsprung 29 entsprechend elastisch verformt. Da der Dichtkörper 3 aus elastomerem Material besteht, wird durch die elastische Verformung des Dichtkörpers 3 eine große Dichtfläche zwischen dem Dichtkörper 3 und den Gehäuseteilen 4, 5 erreicht.

Der Dichtkörper gemäß Fig. 17 hat auf der einen Seite des Tragkörpers 1 wieder zwei ringförmige Vorsprünge 29, die im Unterschied zur vorigen Ausführungsform jedoch gleiche Höhe haben.

Auf der gegenüberliegenden Seite des Tragkörpers 1 ist der Dichtkörper 3 mit nur einem ringförmigen Vorsprung 29 versehen, der gleich ausgebildet ist wie die Vorsprünge 29 auf der gegenüberliegenden Seite. Der Ringvorsprung 29 an der Außenseite 8 des Tragkörpers 1 liegt, in Draufsicht gesehen, mittig zwischen den beiden ringförmigen Vorsprüngen 29 an der Außenseite 7 des Tragkörpers 1, die Abstand voneinander haben.

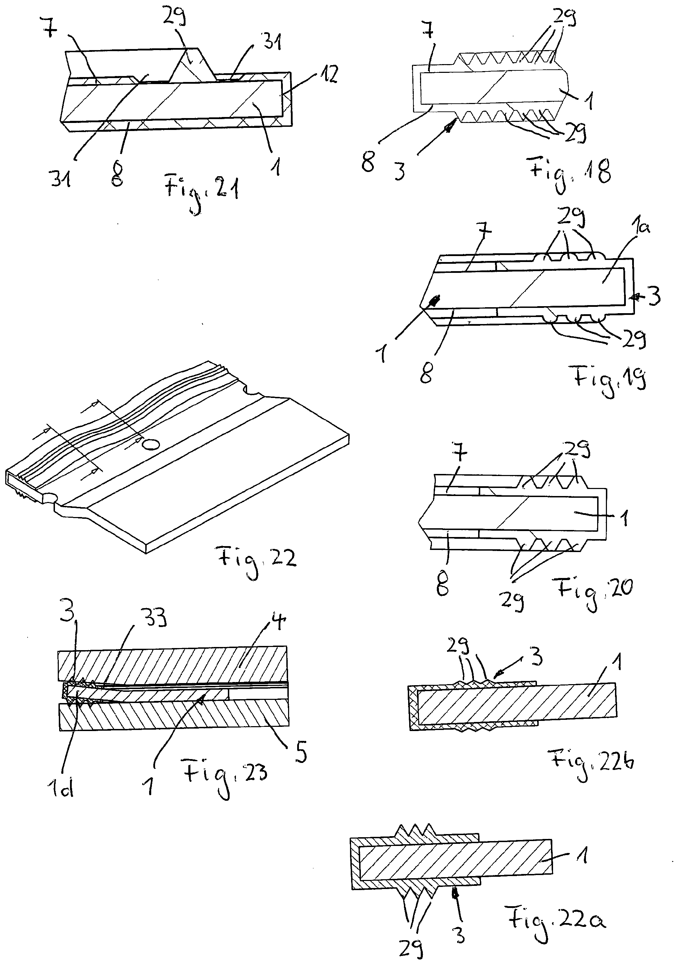

Beim Ausführungsbeispiel nach Fig. 18 hat der Tragkörper 3 auf beiden Außenseiten 7, 8 des Tragkörpers 1 eine gleiche Struktur, die durch eine Vielzahl von nebeneinander liegenden Vorsprüngen 29 gebildet ist, die im Unterschied zu den Ausführungsformen nach den Fig. 16 und 17 aneinander anschließen. Entsprechend den Ausführungsformen nach den Fig. 16 und 17 verjüngen sich die Vorsprünge in Richtung auf ihre Enden. Die Vorsprünge 29 haben gleiche Höhe. Zudem liegen die Vorsprünge 29 auf beiden Seiten des Tragkörpers 1 übereinander.

Beim Ausführungsbeispiel nach Fig. 19 hat der Dichtkörper 3 auf beiden Seiten des Tragkörpers 1 ringförmige Vorsprünge 29, die gleiche Höhe haben. Die Vorsprünge 29 auf beiden Seiten 7, 8 des Tragkörpers 1 liegen jeweils mit Abstand nebeneinander, so dass die grundsätzliche Gestaltung des Dichtkörpers 3 den Ausführungsbeispielen gemäß den Fig. 16 und 17 entspricht.

Die Vorsprünge 29 an der Außenseite 8 sind in Bezug auf die Vorsprünge 29 an der Außenseite 7 versetzt angeordnet, so dass, in Draufsicht auf den Tragkörper 1 gesehen, die Vorsprünge 29 nicht übereinander liegen, sondern in Breitenrichtung des Tragkörperteiles 1a versetzt zueinander angeordnet sind.

Wie Fig. 20 zeigt, können die mit Abstand nebeneinander liegenden ringförmigen Vorsprünge auf beiden Seiten 7, 8 des Tragkörpers 1 auch auf gleicher Höhe liegen, so dass sie, in Draufsicht gesehen, übereinander angeordnet sind.

Während bei den Ausführungsformen nach den Fig. 16 bis 20 der Tragkörper 1 auf beiden Seiten 7, 8 seines äußeren Tragkörperteiles 1a jeweils mit dem Dichtkörper 3 mit seinen Vorsprüngen 29, 30 teilweise bedeckt ist, zeigt Fig. 21 ein Beispiel dafür, dass nur an einer Seite 7 des Tragkörpers 1 ein ringförmiger Vorsprung 29 angeordnet ist. Der Dichtkörper 3 umgibt den Außenrand 12 des Tragkörpers 1 und erstreckt sich bis zur Außenseite 8 des Tragkörpers 1.

Der Dichtkörper 3 ist im Bereich neben dem Vorsprung 29 mit einer Vertiefung 31 versehen. Sie erstreckt sich zu beiden Seiten des Vorsprunges 29 über dessen Länge. Die Vertiefung 31 dient dazu, beim Verpressen des Dichtköpers 3 zwischen den Gehäuseteilen 4, 5 das durch die elastische Verformung des Vorsprunges 29 verdrängte Material aufzunehmen.

Die Fig. 22, 22a und 22b zeigen beispielhaft einen Dichtkörper 3, dessen Vorsprünge 29 in ihrer Längsrichtung unterschiedliche Höhen haben. Der Tragkörperteil 1c ist mit über seine Länge verteilt angeordneten Öffnungen 32 versehen, durch die Schrauben und dgl. gesteckt werden, mit denen die beiden Gehäuseteile 4, 5 unter Zwischenlage der Dichtung miteinander verschraubt werden. Im Bereich zwischen den Öffnungen 32 haben die Vorsprünge 29 eine größere Höhe (Fig. 22a) als im Bereich der Öffnungen 32 (Fig. 22b). So kann die Höhe der Vorsprünge 29 vom Bereich der Öffnungen 32 aus stetig so zunehmen, dass die Vorsprünge 29 in halber Länge zwischen dem Bereich der Öffnungen 32 ihre größte Höhe haben. Durch eine solche Ausbildung wird die Dichtwirkung des Dichtkörpers 3 erhöht. Darüberhinaus wird die Aufbiegung der Gehäuseteile 4, 5 durch die Verschraubung kompensiert und eine gute Abdichtung erreicht.

Die Vorsprünge 29, 30 des Dichtkörpers 3 können bei den beschriebenen Ausführungsformen unterschiedliche Profilformen haben. Auch kann der

Abstand zwischen benachbarten Vorsprüngen 29, 30 variabel gestaltet werden, um die Dichtung an unterschiedliche Anwendungsfälle anzupassen.

Fig. 23 zeigt eine Dichtung, deren Tragkörper 1 am äußeren Rand abgewinkelt ist. Dadurch wird ein kegelförmiger Tragkörperteil 1d gebildet, der den Dichtkörper 3 aufweist. Mit einer solchen Dichtung können Gehäuseteile 4, 5 einwandfrei abgedichtet werden, deren Gussflächen nicht bearbeitet sind. Der Gehäuseteil 4 ist beispielsweise an seiner Dichtfläche im Randbereich mit einer Aufweitung 33 versehen, die mit dem Dichtkörper 3 zuverlässig abgedichtet werden kann.

Mit der Dichtung kann Setzbewegungen der Gehäuseteile 4, 5 und der Schraubverbindung selbst entgegengewirkt werden.

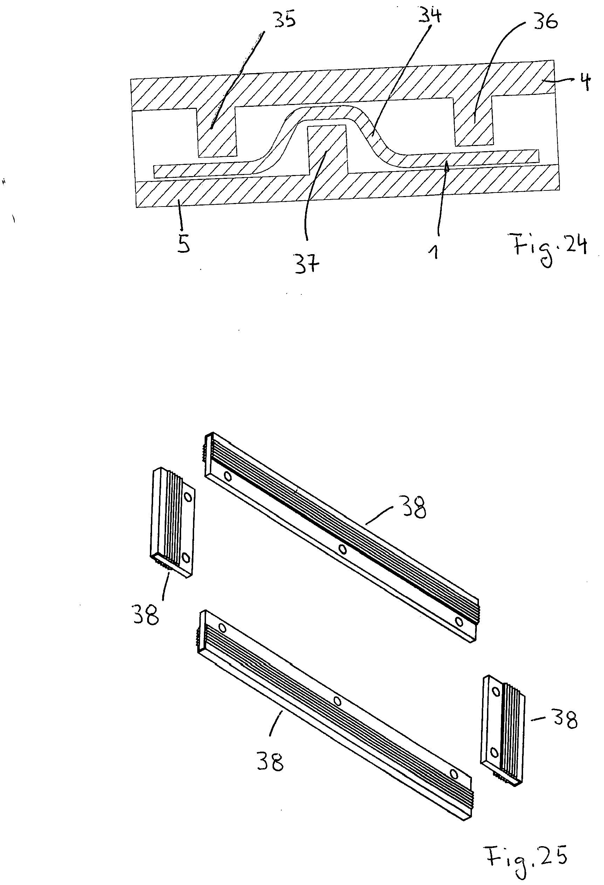

Fig. 24 zeigt eine weitere mögliche Gestaltung des Tragkörpers 1. Er weist eine wellenförmige Erhebung 34 auf, die beim Zusammenschrauben der beiden Gehäuseteile 4, 5 elastisch verformt wird.

Das Gehäuseteil 4 weist beiderseits der Erhebung 34 liegende leistenförmige Vorsprünge 35, 36 auf, die beim Zusammensetzen der Gehäuseteile 4, 5 im Bereich neben der Erhebung 34 auf den ebenen Teil des Tragkörpers 1 drücken.

Der andere Gehäuseteil 5 weist einen leistenförmigen Vorsprung 37 auf, der beim Zusammenfügen der Gehäuseteile 4, 5 in die Erhebung 34 ragt.

Die wellenförmige Erhebung 34 des Tragkörpers sowie die Vorsprünge 35 bis 37 der Gehäuseteile 4, 5 sind so aufeinander abgestimmt, dass beim Zusammenfügen der Gehäuseteile 4, 5 die Erhebung 34 elastisch verformt wird. Die Vorsprünge 35, 36 des Gehäuseteiles 4 dienen als Niederhalter, mit denen der Tragköper 1 im Bereich neben der Erhebung 34 gegen den Gehäuseteil 5 gedrückt wird.

Infolge der elastischen Verformung der Erhebung 34 sind die Gehäuseteile 4, 5 über den Tragkörper 1 einwandfrei elektrisch leitend miteinander verbunden.

Die beschriebenen Dichtungen sind ringförmig ausgebildet. Die Ringform ist aber nicht zwingend erforderlich und ist beispielsweise zur Abdichtung bei längeren Bauteilen, wie etwa Batteriegehäusen von Kraftfahrzeugen, wenig geeignet. In diesen Fällen ist die Dichtung als Dichtleiste 38 ausgebildet (Fig. 25), wobei bei einer eckigen Gestaltung der Dichtfläche dann entsprechende leistenförmige Dichtungen 38 zu einem rechteckigen Dichtungsring zusammengefügt werden. Hierbei liegen die Dichtungsleisten 38 gehrungsartig aneinander. Im Stumpfstoß erfolgt dann die Abdichtung zwischen benachbarten Dichtungsleisten 38, beispielsweise mit Flüssigsilikon.

Auch solche Dichtstreifen 38 haben den beschriebenen Tragkörper, der zwischen den gegeneinander abzudichtenden Gehäuseteilen 4, 5 eingespannt und hierbei elastisch verformt wird. Auf dem Tragkörper ist der Dichtkörper 3 befestigt, der eine Ausbildung entsprechend den zuvor beschriebenen Gestaltungen haben kann.

Beim Verpressen des Tragkörpers 1 zwischen den beiden Gehäuseteilen 4, 5 werden die Tragkörper 1 in der beschriebenen Weise bis auf die Dichthöhe so weit zusammengedrückt, bis die Dichtspalthöhe erreicht ist und der Tragkörper dichtend und elektrisch leitend beide einander zugewandten Seiten der Gehäuseteile 4, 5 geschlossen umlaufend berührt. Der Tragkörper 1 kann in der beschriebenen Weise entsprechende Profilierungen aufweisen, die in vorteilhafter Weise so ausgebildet sind, dass sie eine Oxidschicht, wie sie bei aus Aluminium bestehenden Gehäuseteilen 4, 5 auftritt, durchbricht, so dass die Gehäuseteile 4, 5 trotz der Oxidschicht elektrisch leitend miteinander verbunden sind.

Zur Verbesserung der Leitfähigkeit und zur Korrosionsminderung kann der Tragkörper mit entsprechenden Beschichtungen versehen sein, die bei allen beschriebenen Ausgestaltungen des Tragkörpers 1 eingesetzt werden können.

Die Dichtungen zeichnen sich dadurch aus, dass sie zwei Funktionen erfüllen, nämlich den Eintritt von Schmutzteilen, Wasser und dgl. von außen zwischen die Gehäuseteile 4, 5 zu verhindern und gleichzeitig für die erforderliche EMV-Verträglichkeit zu sorgen. Der Dichtkörper 3 ist vorteilhaft so gestaltet, dass er auch die IP-Forderung Klasse 9K erfüllen kann. Aufgrund der elastischen Verformung des elektrisch leitenden Tragkörpers 1 ergibt sich eine optimale EMV-Wirkung. Da für beide Funktionen nur ein einziges Bauteil erforderlich ist, ergibt sich eine kostengünstige und sehr effektive Abdichtung und Abschirmung. Die Dichtung kann lösbar und schwingungssicher zwischen den beiden Gehäusen 4, 5, die vorteilhaft Druckgussgehäuse sind, umlaufend eingespannt werden. Der Spalt zwischen den Gehäuseteilen 4, 5 wird zuverlässig gegen Eintritt von außen abgedichtet. Gleichzeitig schirmt die Dichtung das aus den Gehäuseteilen 4, 5 gebildete Gehäuse gegen Austritt elektrischer Störquellen ab.

Bei den beschriebenen Ausführungsbeispielen ist die Abschirmwirkung durch den elektrisch leitenden Tragkörper 1 von der für den Dichtkörper 3 notwendigen Mindestflächenpressung unabhängig.

Die Dicke 13 des Tragkörpers 1 ist kleiner als die Dichtspalthöhe zwischen den beiden Gehäuseteilen 4, 5. Dadurch ist sichergestellt, dass der Dichtkörper 3 beim Zusammenfügen der Gehäuseteile 4, 5 zum Gehäuse auf jeden Fall elastisch verformt wird und so seine Dichtwirkung ausüben kann.

Der Dichtkörper 3 dichtet das Gehäuse gegen Staub, gegen Feuchtigkeit oder gegen Salzwasser ab. Insbesondere gewährleistet die Dichtung bzw. ihr Dichtkörper 3 eine Dichtigkeit bei einem Wasserdampfstrahler von bis zu 100bar. Die Dichtung ermöglicht auch Wasserdurchfahrten des Fahrzeuges, so dass in solchen Fällen kein Wasser durch den Spalt zwischen den Gehäuseteilen 4, 5 in das Gehäuse gelangen kann. Dies ist insbesondere ein wesentlicher Vorteil, wenn das Gehäuse ein Batteriegehäuse eines Fahrzeuges ist. Der Dichtkörper 3 ist auch klimawechselfest und salzsprühnebelfest.

Mit dem Tragkörper 1 erfolgt eine Abschirmung gegen Störströme oder Störstrahlungen. Außerdem wird eine elektrostatische Aufladung des Gehäuses verhindert. Um die Vorspannkraft auf Grund der elastischen Verformung des Tragkörpers 1 steuern zu können, kann er in vorteilhafter Weise perforiert sein. Die Perforierung wird dann so vorgesehen, dass die gewünschte Vorspannkraft erreicht wird.

## Patentansprüche

1. Dichtung mit wenigstens einem Tragkörper, an dem wenigstens ein Dichtkörper vorgesehen ist,
**dadurch gekennzeichnet, dass** der Tragkörper (1) zumindest in einem über den Dichtkörper (3) vorstehenden Bereich (1b, 1c) elektrisch leitend ausgebildet ist.

2. Dichtung nach Anspruch 1,
**dadurch gekennzeichnet, dass** der vorstehende Bereich (1c) des Tragkörpers (1) elastisch verformbar ist.

3. Dichtung nach Anspruch 1 oder 2,
**dadurch gekennzeichnet, dass** der gesamte Tragkörper (1) aus elektrisch leitendem Material besteht.

4. Dichtung nach einem der Ansprüche 1 bis 3,
**dadurch gekennzeichnet, dass** der Tragkörper (1) aus elektrisch nicht leitendem Material besteht und zumindest der über den Dichtkörper (3) vorstehende Bereich (1b, 1c) mit einer elektrisch leitenden Beschichtung versehen ist.

5. Dichtung nach einem der Ansprüche 1 bis 4,
**dadurch gekennzeichnet, dass** der Tragkörper (1) aus einem Metallblech gebildet ist.

6. Dichtung nach einem der Ansprüche 1 bis 5,
**dadurch gekennzeichnet, dass** zumindest der vorstehende Bereich (1b, 1c) des Tragkörpers (1) als Formteil ausgebildet ist.

7. Dichtung nach einem der Ansprüche 1 bis 6,
**dadurch gekennzeichnet, dass** der vorstehende Bereich (1b, 1c) des Tragkörpers (1) gegenüber dem den Dichtkörper (3) aufweisenden Bereich (1a) quer zur Ebene des Tragkörpers (1) versetzt angeordnet ist.

8. Dichtung nach einem der Ansprüche 1 bis 7,
**dadurch gekennzeichnet, dass** der vorstehende Bereich (1b, 1c) des Tragkörpers (1) als Formteil eine rippenförmige Struktur (9) aufweist.

9. Dichtung nach einem der Ansprüche 1 bis 8,
**dadurch gekennzeichnet, dass** der vorstehende Bereich (1b, 1c) quer zur Längsrichtung des Tragkörpers (1) profiliert ist.

10. Dichtung nach Anspruch 9,
**dadurch gekennzeichnet, dass** die Profilierung durch in Umfangrichtung hintereinander liegende Profilteile (14) gebildet ist.

11. Dichtung nach Anspruch 10,
**dadurch gekennzeichnet, dass** die Profilteile (14) wellenförmig ausgebildet sind.

12. Dichtung nach einem der Ansprüche 1 bis 11,
**dadurch gekennzeichnet, dass** der vorstehende Bereich (1b, 1c) eine in Längsrichtung des Tragkörpers (1) verlaufende Profilierung (15, 16) aufweist.

13. Dichtung nach Anspruch 12,
**dadurch gekennzeichnet, dass** die Profilierung (15, 16) im Querschnitt wellenförmig ausgebildet ist und sich in Längsrichtung des Tragkörpers (1) erstreckt.

14. Dichtung nach einem der Ansprüche 1 bis 13,
**dadurch gekennzeichnet, dass** der Tragkörper (1) mit Formschlussmitteln (17, 27) versehen ist.

15. Dichtung nach Anspruch 14,
**dadurch gekennzeichnet, dass** sich die Formschlussmittel (17, 27) quer zum Tragkörper (1) erstrecken.

16. Dichtung nach Anspruch 14 oder 15,
**dadurch gekennzeichnet, dass** die Formschlussmittel (27) quer abstehende Laschen sind.

17. Dichtung nach einem der Ansprüche 1 bis 16,
**dadurch gekennzeichnet, dass** der vorstehende Teil (1c) des Tragkörpers (1) mit mindestens einem vorstehenden Zapfen (6) versehen ist.

18. Dichtung nach einem der Ansprüche 1 bis 17,
**dadurch gekennzeichnet, dass** der Dichtkörper (3) an zumindest einer Seite (7, 8) des Tragkörpers (1) mit einer Profilierung (29, 30) versehen ist.

19. Dichtung nach einem der Ansprüche 1 bis 18,
**dadurch gekennzeichnet, dass** die Dicke (13) des Tragkörpers (1) kleiner ist als die Höhe des abzudichtenden Dichtspaltes.
